# FASCICULE DE BREVET EUROPEEN

(11) **EP 0 960 441 B1**
(45) Date de publication et mention de la délivrance du brevet: **02.04.2003**
(21) Numéro de dépôt: 98903092.9
(22) Date de dépôt: 20.01.1998
(51) Int. Cl.: H01L 31/0203, H01L 27/146

(54) **PROCEDE DE SCELLEMENT ETANCHE D'UN DETECTEUR DE RAYONNEMENT ET DETECTEUR OBTENU PAR CE PROCEDE**
VERFAHREN ZUR HERMETISCHEN ABDICHTUNG EINES FESTKÖRPERSTRAHLUNGSDETEKTORS UND NACH DIESEM VERFAHREN HERGESTELLTER DETEKTOR
METHOD FOR TIGHT SEALING OF A RADIATION DETECTOR AND DETECTOR OBTAINED BY THIS METHOD

(30) Priorité: 21.01.1997 FR 9700590
(43) Date de publication de la demande: 01.12.1999
(73) Titulaire: THALES ELECTRON DEVICES S.A., 78140 Vélizy (FR)
(72) Inventeur: VIEUX, Gérard, Thomson-CSF S.C.P.I., F-94117 Arcueil Cedex (FR); SPINNLER, Vincent, Thomson-CSF S.C.P.I., F-94117 Arcueil Cedex (FR)
(74) Mandataire: Guérin, Michel
(86) Numéro de dépôt international: FR9800098
(87) Numéro de publication internationale: WO98032179

(56) Documents cités:
- EP-A- 0 528 676
- EP-A- 0 529 981
- US-A- 5 201 456
- US-A- 5 381 014
- US-A- 5 434 418

## Description

La présente invention concerne un procédé de scellement étanche d'un détecteur de rayonnement, et plus particulièrement d'un détecteur matriciel radiologique de grande dimension constitué par une dalle de verre recouverte de silicium amorphe, le silicium amorphe constituant le matériau actif des détecteurs élémentaires de la matrice de détection.

L'invention s'applique aux détecteurs de rayonnement de longueurs d'onde très courtes, plus particulièrement aux rayonnements X utilisés en radiologie.

Selon la technologie actuelle, les détecteurs de rayonnement sont réalisés à base d'une matrice d'éléments photosensibles à l'état solide. Les éléments photosensibles à l'état solide connus ne sont pas sensibles directement aux rayons de longueurs d'onde très courtes, par exemple des rayons X. Il est nécessaire de les associer à un organe scintillateur. Celui-ci est réalisé en une substance qui a la propriété, lorsqu'elle est excitée par ces rayons X, d'émettre une lumière dans une gamme de longueurs d'onde plus grandes : dans le visible (ou le proche visible). La longueur d'onde précise dépend de la substance utilisée. Le scintillateur agit donc comme un convertisseur de longueurs d'onde. La lumière visible ainsi générée est transmise aux éléments photosensibles qui effectuent une conversion photoélectrique de l'énergie lumineuse reçue en signaux électriques exploitables par des circuits électroniques appropriés.

Un scintillateur selon l'art connu est décrit, à titre d'exemple non limitatif, dans la demande de brevet français FR-A-2 636 800 (THOMSON-CSF) et dans US-A- 5434418.

Les figures 1a à 1e, annexées à la présente description, illustrent le fonctionnement d'un détecteur de rayonnement matriciel de grande dimension selon l'art connu, formé par une dalle de verre recouverte de silicium amorphe. Plus particulièrement, la figure 1e montre un exemple de structure pratique d'un tel détecteur.Les dimensions du détecteur sont typiquement de une ou plusieurs dizaines de centimètres de côté, le détecteur pouvant d'ailleurs être formé par plusieurs dalles de verre raboutées lorsque les dimensions sont particulièrement grandes.

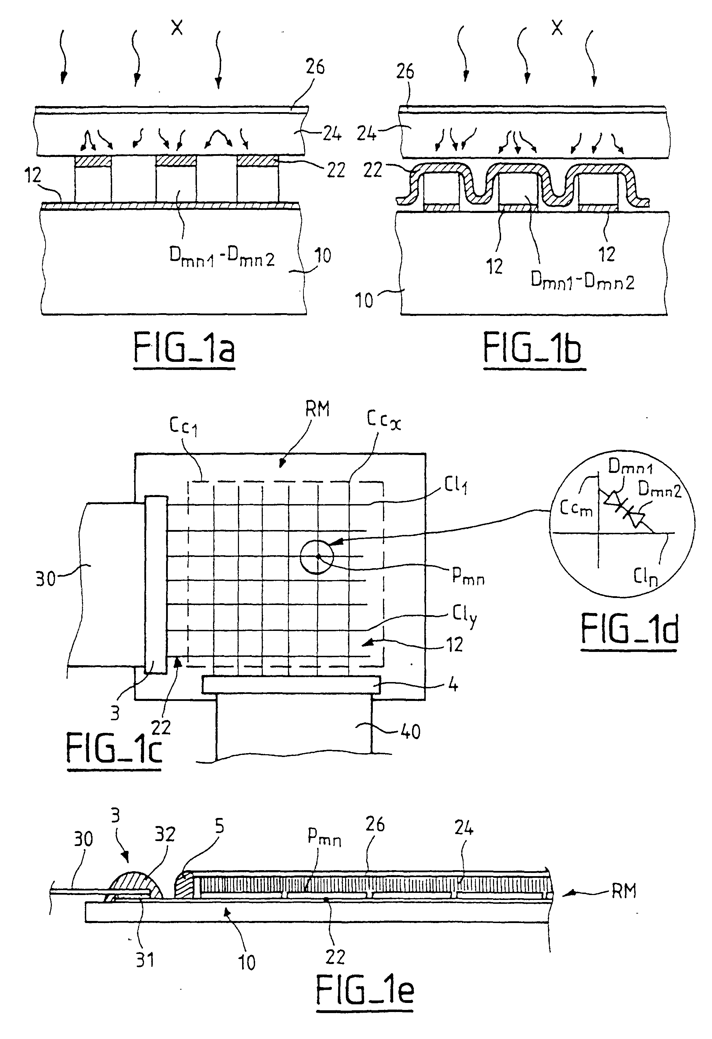

Les figures 1a et 1b représentent deux coupes latérales, orthogonales l'une à l'autre, d'une matrice d'éléments photosensibles associée classiquement à une feuille de substance scintillatrice.

Chaque élément photosensible comporte une photodiode ou un phototransistor, sensible aux photons, dans le visible ou le proche visible. A titre d'exemple, comme illustré sur les figures 1a à 1d, chaque élément photosensible est constitué, par exemple, de deux diodes, Dₘₙ₁ et Dₘₙ₂, disposées tête-bêche et le réseau matriciel RM comporte des conducteurs de colonnes, Cc₁ à Ccₓ, et des conducteurs de lignes, Cl₁ à Cly. Chacune des diodes, Dₘₙ₁ et Dₘₙ₂, constitue de manière connue, une capacité quand elle est polarisée en inverse. La première diode, Dₘₙ₁, a une capacité typiquement dix fois moins importante que la capacité de le seconde diode, Dₘₙ₂. Elle joue principalement le rôle de commutateur, alors que la seconde diode est préférentiellement photodétectrice.

A chaque croisement d'une ligne et d'une colonne, par exemple de la ligne Clₙ et de la colonne Ccₘ (voir Figure 1d), on dispose un tel ensemble de deux diodes tête-bêche, Dₘₙ₁ et Dₘₙ₂. Les diodes, réalisées en silicum amorphe, peuvent être remplacées par des transistors réalisés en technologie "TFT", de l'anglo-saxon "Thin Film Transistor" ou "transistor en couches minces", également à base de silicium amorphe.

Les conducteurs 12 (figures 1a et 1b) sont constitués par un dépôt de métal sur un substrat isolant 10, de préférence du verre. Le dépôt est suivi d'une opération de photogravure, pour obtenir des pistes conductrices parallèles de largeur appropriée. Les diodes (par exemple, Dₘₙ₁ et Dₘₙ₂) sont formées par dépôt, sur les pistes conductrices de colonnes 12, puis gravure, des couches de silicium amorphe (Sia), intrinsèque ou dopé à l'aide de matériaux semi-conducteurs de type P ou N. Une couche très fine de matériau conducteur, de préférence transparent, est déposée sur la couche isolante 20, de manière à former, après gravure, les pistes conductrices de lignes 22 du réseau matriciel RM.

L'ensemble précédemment décrit forme ce qui est généralement appelé une "dalle de silicium amorphe". Le substrat de la dalle est en principe en verre du fait du faible coût de ce matériau.

Les conducteurs de lignes, Cl₁-Clₓ, et les conducteurs de colonnes, Cc₁-Cc_{y}, constituent les électrodes de polarisation des condensateurs de diodes. Ces derniers stockent des charges électriques lorsqu'ils sont soumis à un rayonnement lumineux et délivrent un signal électrique, proportionnel à la charge stockée, lorsqu'elles sont polarisées électriquement. L'adressage des conducteurs de lignes, Cl₁-Clₓ, et des conducteurs de colonnes, Cc₁-Cc_{y}, s'effectue selon une chronologie appropriée, de manière à ce que tous les pixels pₘₙ soient polarisés séquentiellement dans un ordre prédéterminé. Le signal délivré par chaque pixel pₘₙ est ainsi récupéré et traité par des circuits électroniques (non représentés), de façon à reconstituer (point par point) l'image stockée sous forme de charges électriques.

Les signaux sont récupérés dans des zones de connectique respectives, 3 et 4, pour les lignes, Cl₁-Clₓ, et les colonnes, Cc₁-Cc_{y}. Les connexions avec les circuits électroniques peuvent être réalisées à l'aide de câbles souples multiconducteurs, 30 et 40, respectivement. Les câbles souples multiconducteurs ont leurs extrémités fixées par collage ou soudage ou de préférence par pressage à chaud sur les zones périphériques de connectique. Plus précisément, on les réalise habituellement par un procédé de flexage, c'est-à-dire en pressant à chaud un film conducteur anisotrope, appelé ci-après "ACF", entre des plots de contact situés sur la dalle de verre (substrat 10) et des plots correspondants situés sur un câble souple externe 30. Les plots conducteurs peuvent être réalisés sur la dalle par dépôt sous vide. L'ACF a pour particularité de présenter une conduction électrique après pressage à chaud, ce uniquement dans l'axe de la pression exercée. Suivant les autres axes, l'isolement électrique est préservé.

Après flexage, l'ACF nécessite d'être protégé du milieu extérieur afin de conserver ses propriétés d'adhérence et de conductivité électrique, notamment dans des conditions d'environnement difficiles : chaleur humide, par exemple. Plus généralement, quelle que soit la méthode de fixation et la nature du câble souple, l'extrémité du câble souple multiconducteur doit être protégée dans la zone de connexion.

Comme il a été indiqué, les éléments photosensibles doivent être illuminés par de la lumière visible (ou dans une gamme proche de la lumière visible). Il est nécessaire de disposer d'un scintillateur qui convertit les rayons X en énergie lumineuse dans le spectre visible. Pour ce faire, il suffit de recouvrir la dalle silicium amorphe, précédemment décrite, d'une couche de substance scintillatrice 24. A titre d'exemple, pour un détecteur sensible aux rayons X de l'ordre de 60 keV, on utilise comme substance scintillatrice de l'iodure de césium (CsI) dopé à l'iodure de sodium (NaI) ou de thallium (TiI), selon que l'on souhaite obtenir un signal lumineux de longueur d'onde 390 nm ou 550 nm, respectivement. La couche de substance scintillatrice 24 est généralement réalisée par évaporation sous vide. Cette dernière opération est généralement suivie d'un recuit de la couche, ce qui permet une diffusion homogène du dopant au sein de la structure en iodure de césium. La diffusion ainsi obtenue permet d'optimiser la conversion des rayons X en lumière visible.

La méthode de réalisation d'un scintillateur la plus simple consiste à déposer une couche d'iodure de césium sur un substrat quelconque, de la recuire afin d'obtenir des propriétés de luminescence et de rapporter cet ensemble scintillateur contre la dalle décrite précédemment. Plus précisément, ce scintillateur rapporté peut être, soit plaqué contre la dalle, soit couplé optiquement par collage.

Le scintillateur, qui est par nature hygroscopique, doit être impérativement protégé du milieu extérieur, afin de préserver les propriétés de luminescence. Cette protection peut être réalisée en isolant le scintillateur de l'atmosphère extérieure par un scellement étanche en périphérie du substrat du scintillateur. On peut fixer le substrat sur la dalle par un cordon de colle imperméable à l'humidité. Le substrat, par son imperméabilité, participe également à la protection du scintillateur.

Les performances obtenues avec un scintillateur ainsi réalisé sont toutefois moyennes, notamment en terme de résolution. On observe en effet une réfraction de la lumière visible issue du scintillateur, soit dans l'épaisseur de la colle dans le cas du couplage sur la dalle, soit dans l'épaisseur de la lame d'air difficile à maîtriser dans le cas du plaquage sur la dalle.

Une méthode plus performante de réalisation du scintillateur, toujours en terme de résolution, consiste à réaliser celui-ci par évaporation directe de matériau sur la dalle. Cette solution présente l'avantage d'obtenir un scintillateur en contact intime avec la dalle. La diffusion de lumière à l'interface scintillateur/dalle et la perte de résolution qui en résultent sont réduites au minimum.

La protection du scintillateur peut alors être réalisée de la manière suivante : on plaque, sur la couche de substance scintillatrice 24, une fenêtre 26 d'entrée aux rayons X. Cette fenêtre est constituée à base d'un matériau tel que l'aluminium, un matériau plastique ou tout autre matériau approprié transparent aux rayons X. On réalise un scellement étanche comme précédemment. La fenêtre d'entrée et le cordon de scellement participent également à cette protection.

La figure 1e illustre, en coupe, la structure partielle d'un détecteur selon l'art connu, du type qui vient d'être rappelé.

La chronologie habituelle des opérations est la suivante :
a/ on réalise tout d'abord le dépôt du scintillateur (couche 24) sur un substrat 26 ;
b/ on réalise le scellement étanche 5 du substrat 26 sur la dalle 10 supportant les éléments photosensibles (définissant les pixels pₘₙ) et les conducteurs de lignes 22 et de colonnes (non représentés) ;
c/ on réalise l'opération de connexion électrique par flexage : zone 31 ;
d/ on réalise la protection de la zone de flexage, par exemple par un cordon de colle 32.

Bien que ce procédé permette une protection effective du scintillateur et de la zone de connectique, elle présente cependant des inconvénients résiduels.

En premier lieu, les contraintes dimensionnelles des détecteurs de technologie récente sont telles que l'on cherche, lors de leur conception, à minimiser autant que faire se peut leur poids et leur encombrement. Il est donc nécessaire de minimiser les zones inutiles entre le réseau matriciel actif de pixels et la zone de connectique.

En second lieu, le matériau de protection de la zone de connectique et matériau du cordon de scellement du scintillateur n'étant pas, a priori, de mêmes natures et compatibles entre eux, les deux opérations étant en outre indépendantes, le procédé selon l'art connu impose de définir sur la dalle de verre des zones séparées dédiées aux deux opérations. Ceci est donc préjudiciable en terme d'encombrement et augmente le temps de fabrication en multipliant le nombre d'opérations.

L'invention se fixe pour but, d'une part, de pallier les inconvénients des procédés de l'art connu qui ont été rappelés, et, d'autre part, de répondre aux besoins qui se font sentir.

Pour ce faire, le procédé selon l'invention permet de réaliser une protection simultanée de la zone de connectique et du scintillateur, protection obtenue par le dépôt d'un matériau imperméable à l'humidité atmosphérique. Dans une variante de réalisation préférée, le dépôt s'effectue par sérigraphie.

L'invention a donc pour objet un procédé de scellement étanche d'un détecteur de rayonnement matriciel de grande dimension constitué par une dalle de verre recouverte de silicium amorphe, la dalle comprenant au moins, d'une part, une pluralité de détecteurs élémentaires formés sur une zone centrale d'un substrat isolant et, d'autre part, une couche de substance scintillatrice ; lesdits détecteurs élémentaires étant reliés à des zones périphériques de connectique sur lesquelles sont fixés des câbles souples multiconducteurs, ledit procédé comprenant au moins une étape de dépôt d'une couche de matériau étanche à l'humidité atmosphérique recouvrant en une seule opération à la fois lesdites zones périphériques de connectique et au moins la périphérie de ladite couche de substance scintillatrice.

L'invention sera mieux comprise et d'autres caractéristiques et avantages apparaîtront à la lecture de la description qui suit en référence aux figures annexées, parmi lesquelles :
- les figures 1a à 1e illustrent schématiquement le fonctionnement et la structure d'un détecteur matriciel sur dalle de silicium amorphe selon l'art connu;
- la figure 2 illustre un premier exemple de réalisation d'un détecteur conforme à l'invention ;
- et la figure 3 illustre un second exemple de réalisation d'un détecteur conforme à l'invention.

On va décrire le procédé selon l'invention par référence aux modes de réalisation du détecteur selon l'invention.

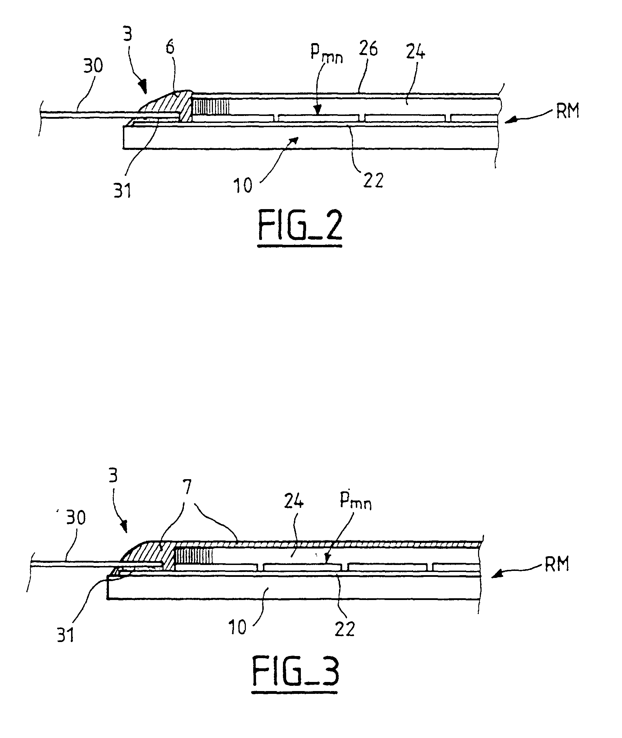

La figure 2 illustre, en coupe, un premier exemple de réalisation d'un détecteur selon l'invention. Les éléments communs avec le détecteur de la figure le portent les mêmes références et ne seront redécrits qu'en tant que de besoin.

La structure générale d'un détecteur telle qu'elle a été rappelée en regard des figures 1a à 1e est conservée. Plus particulièrement, la structure du détecteur selon la variante de la figure 2 s'apparente à celle décrite en relation avec le détecteur de l'art connu de la figure 1e.

Le scintillateur 24 peut être réalisé par évaporation directe. L'organe 26 est alors une fenêtre dite "d'entrée", constituée par une feuille de matériau étanche à l'humidité atmosphérique (aluminium, matériau plastique ou verre, par exemple). Le scintillateur 24 peut également être rapporté sur la dalle, comme il a été décrit précédemment. L'organe 26 est alors un substrat sur lequel a été déposé la substance scintillatrice.

Selon une caractéristique importante de l'invention, la protection de la zone périphérique de connectique, sur laquelle sont fixés les extrémités de câble souple multiconducteurs, et la protection de la périphérie du scintillateur 24 et de sa fenêtre d'entrée 26 sont réalisées en une seule opération.

Pour ce faire, on procède au dépôt d'un matériau imperméable à l'humidité atmosphérique. Ce matériau recouvre la zone de flexage et s'étend sur la périphérie du scintillateur 24 (et de la fenêtre d'entrée ou du substrat 26) : cordon d'étanchéité 6.

Le dépôt s'effectue préférentiellement par sérigraphie. Il peut également s'effectuer à l'aide d'une machine de dispense mécanique, par toute autre méthode de dépôt ou par une combinaison des méthodes précédentes.

La figure 3 illustre schématiquement, en coupe, un second exemple de réalisation d'un détecteur selon l'invention. La structure représentée correspond au cas où le scintillateur 24 est réalisé par évaporation directe, comme il a été décrit précédemment.

Le scellement est réalisé par le dépôt d'une couche 7 d'un matériau étanche à l'humidité atmosphérique sur l'intégralité de la surface du scintillateur 24. La couche 7 déborde sur la périphérie, vers l'extérieur, de manière à recouvrir aussi la zone de connectique 3 et, notamment la zone de flexage 31. Il est en effet nécessaire de protéger l'intégralité de la surface du scintillateur 24, puisqu'il ne comporte pas d'autre moyen de protection.

Le dépôt proprement dit peut s'effectuer de manière tout à fait similaire à ce qui a été réalisé précédemment : sérigraphie, etc.

A la lecture de ce qui précède, on constate aisément que l'invention atteint bien les buts qu'elle s'est fixés.

Le procédé selon l'invention présente donc de nombreux avantages et parmi ceux-ci les suivants : simplicité, coût moins élevé et réduction de l'encombrement.

Il doit être clair aussi que, bien que particulièrement adaptée à des détecteurs de rayons X du type rappelé, on ne saurait cantonner l'invention à ce seul type d'applications. Elle s'applique tout aussi bien à tous types de détecteur de rayonnement comportant une zone de connectique périphérique et un scintillateur. Il peut s'agir d'un détecteur élémentaire ou d'un détecteur de grande dimension, constitué par l'assemblage de détecteurs élémentaires. Un détecteur de ce dernier type est décrit, à titre d'exemple non limitatif, dans la demande de brevet français FR-A-2 687 494 (THOMSON TUBES ELECTRONIQUES).

## Revendications

1. Procédé de scellement étanche d'un détecteur de rayonnement matriciel de grande dimension constitué par une dalle de verre recouverte de silicium amorphe, la dalle comprenant au moins, d'une part, une pluralité (RM) de détecteurs élémentaires (pₘₙ) formés sur une zone centrale d'un substrat isolant (10) et, d'autre part, une couche de substance scintillatrice (24) ; lesdits détecteurs élémentaires (pₘₙ) étant reliés à des zones périphériques de connectique (3) sur lesquelles sont fixés des câbles souples multiconducteurs, **caractérisé en ce qu'**il comprend au moins une étape de dépôt d'une couche de matériau (6, 7) étanche à l'humidité atmosphérique recouvrant en une seule opération à la fois lesdites zones périphériques de connectique (3) et au moins la périphérie de ladite couche de substance scintillatrice (24).

2. Procédé selon la revendication 1, **caractérisé en ce que**, ladite couche de substance scintillatrice (24) étant réalisée par évaporation directe sur ledit substrat (10) supportant la pluralité de détecteurs élémentaires (pₘₙ), le dépôt de ladite couche de matériau (7) étanche à l'humidité atmosphérique est réalisé de telle sorte qu'il recouvré complètement la couche de substance scintillatrice (24).

3. Procédé selon la revendication 1 ou 2, **caractérisé en ce que** le dépôt de ladite couche de matériau (6, 7) étanche à l'humidité atmosphérique est effectué par sérigraphie.

4. Procédé suivant la revendication 1 ou 2, **caractérisé en ce que** le dépôt de ladite couche de matériau (6, 7) étanche à l'humidité atmosphérique est effectué à l'aide d'une machine de dispense mécanique.

## Claims

1. Process for leaktight sealing of a matrix radiation detector of large size consisting of a glass slab covered with amorphous silicon, the slab comprising at least, on the one hand, a plurality (RM) of elementary detectors (pₘₙ) which are formed on a central zone of an insulating substrate (10) and, on the other hand, a layer of scintillating substance (24); the said elementary detectors (pₘₙ) being connected to peripheral connection zones (3) to which flexible multiconductor cables are fixed, **characterized in that** it comprises at least one step of depositing a layer of material (6, 7) impermeable to atmospheric moisture covering, in a single operation, both the said peripheral connection zones (3) and at least the periphery of the said layer of scintillating substance (24).

2. Process according to Claim 1, **characterized in that**, the said layer of scintillating substance (24) being produced by direct evaporation onto the said substrate (10) supporting the plurality of elementary detectors (pₘₙ), the deposition of the said layer of material (7) impermeable to atmospheric moisture is carried out in such a way that this deposition completely covers the layer of scintillating substance (24).

3. Process according to Claim 1 or 2, **characterized in that** the deposition of the said layer of material (6, 7) impermeable to atmospheric moisture is carried out by screen printing.

4. Process according to Claim 1 or 2, **characterized in that** the deposition of the said layer of material (6, 7) impermeable to atmospheric moisture is carried out by using a mechanical dispensing machine.

## Patentansprüche

1. Verfahren zum dichten Versiegeln eines matrixförmigen Strahlungsdetektors großer Abmessungen, bestehend aus einer Glasplatte, die mit amorphem Silizium bedeckt ist und mindestens einerseits eine Vielzahl (RM) von Elementardetektoren (pₘₙ), die auf einer zentralen Zone eines isolierenden Substrats (10) ausgebildet sind, und andrerseits eine Schicht (24) aus Szintillatorsubstanz enthält, wobei die Elementardetektoren (pₘₙ) an randseitige Anschlußzonen (3) angeschlossen sind, in denen biegsame vieladrige Kabel befestigt sind, **dadurch gekennzeichnet, daß** es mindestens einen Schritt aufweist, bei dem eine Schicht (6, 7) aus einem gegen atmosphärische Feuchtigkeit dichten Material aufgebracht wird, die in einer einzigen Operation sowohl die randseitigen Anschlußzonen (3) als auch mindestens den Rand der Schicht (24) aus Szintillatorsubstanz bedeckt.

2. Verfahren nach Anspruch 1, **dadurch gekennzeichnet, daß** die Schicht (24) aus Szintillatorsubstanz durch direktes Aufdampfen auf das die Vielzahl von Elementardetektoren (pₘₙ) tragende Substrat (10) erfolgt und daß das Aufbringen der Schicht (7) aus einem gegen die atmosphärische Feuchtigkeit dichten Material so erfolgt, daß sie die Schicht (24) aus Szintillatorsubstanz vollständig bedeckt.

3. Verfahren nach Anspruch 1 oder 2, **dadurch gekennzeichnet, daß** das Aufbringen der Schicht (6, 7) aus gegen die atmosphärische Feuchtigkeit dichtem Material durch Serigraphie erfolgt.

4. Verfahren nach Anspruch 1 oder 2, **dadurch gekennzeichnet, daß** das Aufbringen der Schicht (6, 7) aus gegen die atmosphärische Feuchtigkeit dichtem Material mithilfe einer mechanischen Verteilmaschine aufgebracht wird.
